# EUROPEAN PATENT SPECIFICATION

(11) **EP 1 381 656 B1**
(45) Date of publication and mention of the grant of the patent: **10.11.2010**
(21) Application number: 02717727.8
(22) Date of filing: 27.03.2002
(51) Int. Cl.: C09K 13/00, C09K 13/06, C09K 13/08, H01L 21/02

(54) **AQUEOUS CLEANING COMPOSITION CONTAINING COPPER-SPECIFIC CORROSION INHIBITOR FOR CLEANING INORGANIC RESIDUES ON SEMICONDUCTOR SUBSTRATE**
WÄSSRIGES REINIGUNGSMITTEL MIT KUPFERSPEZIFISCHEM KORROSIONSSCHUTZMITTEL ZUR ABREINIGUNG ANORGANISCHER RESTE VON HALBLEITERSUBSTRATEN
COMPOSITION DE NETTOYAGE AQUEUSE RENFERMANT UN INHIBITEUR DE CORROSION SPECIFIQUE AU CUIVRE, DESTINEE AU NETTOYAGE DE RESIDUS INORGANIQUES SITUES SUR DES SUBSTRATS SEMI-CONDUCTEURS

(30) Priority: 27.03.2001 US 818073
(43) Date of publication of application: 21.01.2004
(73) Proprietor: ADVANCED TECHNOLOGY MATERIALS, INC., Danbury, CT 06810 (US)
(72) Inventor: WOJTCZAK, William, A., Austin, TX 78737 (US); SEIJO, Fatima, Ma., Hayward, CA 94541 (US); BERNHARD, David, Newtown, CT 06470 (US); NGUYEN, Long, San Jose, CA 95121 (US)
(74) Representative: Schüssler, Andrea
(86) International application number: PCT/US2002/009401
(87) International publication number: WO 2002/077120

(56) References cited:
- EP-A2- 0 678 571
- WO-A-98/30667
- US-A- 4 759 582
- US-A- 5 094 701
- US-A- 5 094 701
- US-A- 5 334 332
- US-A- 5 466 389

## Description

### Field of the Invention

The present invention relates generally to chemical formulations useful in semiconductor manufacturing and particularly to chemical formulations that are utilized to remove residue from wafers following a resist plasma ashing step. More specifically, the present invention relates to cleaning formulations for removal of inorganic residue from semiconductor wafers containing delicate copper interconnecting structures.

### Description of the Prior Art

The prior art teaches the utilization of various chemical formulations to remove residues and clean wafers following a resist ashing step. Some of these prior art chemical formulations include akaline compositions containing amines and/or tetraalkyl ammonium hydroxides, water and/or other solvents, and chelating agents. Still other formulations are based on acidic to neutral solutions containing ammonium fluoride. WO-A-98/30667 describes a wafer cleaning formulation comprising ammonium fluoride, an organic amine, water and optionally a metal chelating agent.

The various prior art formulations have drawbacks that include unwanted removal of metal or insulator layers and the corrosion of desirable metal layers, particularly copper or copper alloys features. Some prior art formulations employ corrosion inhibiting additives to prevent undesirable copper metal corrosion during the cleaning process. However, conventional corrosion-inhibiting additives typically have detrimental effects on the cleaning process because such additives interact with the residue and inhibit dissolution of such residue into the cleaning fluid. Moreover, conventional additives do not easily rinse off the copper surface after completion of the cleaning process. Such additives therefore remain on the surface sought to be cleaned, and result in contamination of the integrated circuits. Contamination of the integrated circuit can adversely increase the electrical resistance of contaminated areas and cause unpredictable conducting failure within the circuit.

The formulation of post CMP cleaners for advanced integrated circuit manufacturing such as copper and tungsten interconnect materials, includes slurry removal and residue dissolution components that accelerate the physical cleaning process. However, these conventional additives typically have detrimental effects on the metal surface by increasing resistance and corrosion sensitivity.

It is therefore one object of the present invention to provide chemical formulations that effectively remove residue following a resist ashing step, and which do not attack and potentially degrade delicate structures intended to remain on the wafer.

It is another object of the present invention to replace conventional additives with an improved corrosion inhibitor for protection of copper structures on the semiconductor substrate.

It is another object of the invention to provide an improved corrosion inhibitor, which is easily rinsed off the substrate by water or other rinse medium after the completion of the residue-removal process, thereby reducing contamination of the integrated circuit.

Other objects and advantages of the invention will become fully apparent from the ensuing disclosure and appended claims.

### SUMMARY OF THE INVENTION

The present invention relates generally to chemical formulations useful in semiconductor manufacturing for removing residue from wafers following a resist plasma ashing step.

In one aspect, the invention relates to a method of removing residue from a wafer following a resist plasma ashing step on such wafer, comprising contacting the wafer with a cleaning formulation, including (i) a fluoride source, (ii) at least one organic amine, (iii) a nitrogen-containing carboxylic acid or an imine, (iv) water, and optionally at least one metal chelating agent.

Another aspect of the invention relates to a wafer cleaning formulation, including (i) a fluoride source, (ii) at least one organic amine, (iii) a nitrogen-containing carboxylic acid or an imine, (iv) water, and optionally at least one metal chelating agent.

In a further aspect, the invention relates to a semiconductor wafer cleaning formulation for use in post plasma ashing semiconductor fabrication, comprising the following components in the percentage by weight (based on the total weight of the formulation) ranges shown:

| | |
|---|---|
| a fluoride source, e.g., ammonium fluoride and/or derivative(s) thereof | 1-21% |
| organic amine(s) | 20-55% |
| a nitrogenous component selected from nitrogen-containing carboxylic acids and imines | 0.5-40% |
| water | 23-50% |
| metal chelating agent(s) | 0-21% |
| TOTAL | 100% |

Such formulations of the invention effectively remove inorganic residues following a plasma ashing step.

Such formulations also effectively remove metal halide and metal oxide residues following plasma ashing, and effectively remove slurry particles of aluminum oxides and other oxides remaining after CMP (chemical mechanical polishing).

The formulations of the present invention provide better stripping performance with less corrosivity than formulations containing either ammonium fluoride or amines. Formulations in accordance with the invention also provide better stripping performance at lower processing temperatures than conventional amine-containing formulations.

The formulations of the invention utilize a chelating agent, which may be a single-component chelating agent or a multicomponent chelating agent, to prevent metal corrosion and increase stripping effectiveness.

Other features and advantages of the present invention will be from the ensuing disclosure and appended claims.

### BRIEF DESCRIPTION OF THE DRAWINGS

FIGURE 1 is a schematic representation of a copper-specific corrosion inhibitor useful in the broad practice of the present invention, which forms a protective layer on the copper metal to prevent corrosion;
FIGURE 2 is a schematic representation of the copper-specific corrosion inhibitor being rinsed away from the copper surface by deionized water;
FIGURE 3 depicts cleaning components of the present invention interacting with a surface;
FIGURE 4 illustrates that formulations of the present invention maybe used to remove residues and particles;
FIGURE 5 provides a SEM representing results obtained from an immersion process; and
FIGURE 6 illustrates the material etch rate on interconnect materials.

### DETAILED DESCRIPTION OF THE PREFERRED EMBODIMENTS

The formulations of the present invention are suitable for stripping inorganic wafer residues deriving from high density plasma etching followed by ashing with oxygen-containing plasmas. Such formulations are also suitable for removing slurry particles of aluminum oxides and other oxides remaining after CMP (chemical mechanical polishing).

The formulations advantageously contain (i) a fluoride source, such as ammonium fluoride and/or derivative(s) of ammonium fluoride, (ii) an amine or mixture of amines, (iii) a nitrogen-containing carboxylic acid or imine, (iv) water, and, optionally and preferably, (v) one or more metal chelating agents.

As used herein, a fluoride source refers to a compound or a mixture of compounds that in the aqueous cleaning formulation provides fluorine anions.

The preferred formulations the following components in the percentage by weight (based on the total weight of the formulation) ranges shown:

| | |
|---|---|
| fluoride source | 1-21% |
| organic amine(s) | 20-55% |
| a nitrogenous component selected from nitrogen-containing carboxylic acids and imines | 0.5-40% |
| water | 23-50% |
| metal chelating agent(s) | 0-21% |
| TOTAL | 100% |

The components of the formulation as described above can be of any suitable type or species, as will be appreciated by those of ordinary skill in the art. Specific illustrative and preferred formulation components for each of the ingredients of the formulation are described below.

Particular preferred amines include the following:
diglycolamine (DGA)
methyldiethanolamine (MDEA)
pentamethyldiethylenetriamine (PMDETA)
triethanolamine (TEA)
triethylenediamine (TEDA)

Other amines that are highly advantageous include:
hexamethylenetetramine
3, 3-iminobis (N,N-dimethylpropylamine) monoethanolamine

Specific preferred fluoride sources include:
ammonium fluoride
triethanolammonium fluoride (TEAF)

Other fluoride sources that are highly advantageous include:
diglycolammonium fluoride (DGAF)
tetramethylammonium fluoride (TMAF)
triethylamine tris (hydrogen fluoride) (TREAT-HF)

Specific preferred nitrogen-containing carboxylic acids and imines include
iminodiacetic acid
glycine
nitrilotriacetic acid
1,1,3,3-tetramethylguanidine

Other nitrogen-containing carboxylic acids or imines advantageously utilizable in formulations of the invention include:

CH₃C(=NCH₂CH₂OH)CH₂C(O)N(CH₃)₂

CH₃C(=NCH₂CH₂OCH₂CH₂OH)CH₂C(O)N(CH₃)₂

CH₃C(=NH)CH₂C(O)CH₃

(CH₃CH₂)₂NC(=NH)N(CH₃CH₂)₂

HOOCCH₂N(CH₃)₂

HOOCCH₂N(CH₃)CH₂COOH

Specific preferred metal chelating agents include:
acetoacetamide
ammonium carbamate
ammonium pyrrolidinedithiocarbamate (APDC)
dimethyl malonate
methyl acetoacetate
N-methyl acetoacetamide
2,4-pentanedione
tetramethylammonium thiobenzoate
tetramethylammonium trifluoroacetate
tetramethylthiuram disulfide (TMTDS)

The combination of ammonium fluoride or a substituted fluoride source, as described above, with an amine (other than an amine present as a surfactant in an amount of 1% or less) provides better stripping performance with less corrosivity than formulations containing either ammonium fluoride or amines alone. In addition, the resulting alkaline solutions are effective at lower processing temperatures (e.g., 21°-40°C) than conventional amine-containing formulations.

The presence of nitrogen-containing carboxylic acids and/or imines enables formulations of the invention to be remarkably effective in stripping residues from semiconductor substrate surfaces containing delicate copper structures.

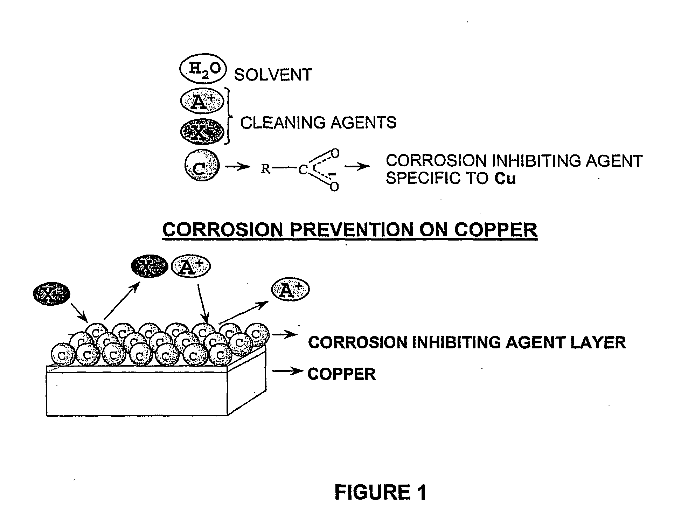

The nitrogen-containing carboxylic acids or imines provide functional groups that are specifically attracted to free copper atoms. As shown schematically in FIGURE 1, the copper-specific corrosion inhibiting-agent C, while contacts the copper surface during the residue-removal process, will attach to the copper surface and form a protective layer to prevent the copper surface being corroded by cleaning agents A⁺ and X⁻.

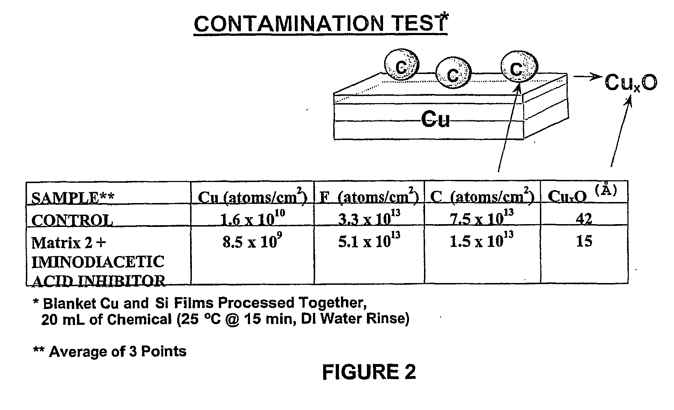

Moreover, as shown by FIGURE 2, such copper-specific corrosion-inhibiting agent C can be easily rinsed off by deionized water or other solutions and therefore leaves very little contamination on the copper surface after the cleaning operation.

The use of 1,3-dicarbonyl compounds as chelating agents and to prevent metal corrosion is a preferred feature of the inventive formulations, to increase their effectiveness.

In various prior art formulations, amines are present in amounts of 1% or less of the formulation as surfactants, or otherwise are not utilized as formulation ingredients at all. Additionally, the prior art formulations are acidic (pH < 7) in character. In preferred formulations of the present invention, the amines are present as major components of the formulation, are highly effective in stripping action, and yield formulations of a basic pH character (pH > 7).

The formulations of the invention may include a wide variety of organic amines, substituted ammonium fluorides, and nitrogen-containing carboxylic acids, other than those specifically exemplified. Particular substituted ammonium fluorides of suitable character include those of the general formula, R₁R₂R₃R₄NF in which each of the respective R species is independently selected from hydrogen and aliphatic groups. Suitable nitrogen-containing carboxylic acids include those of the general structure COOH-CH₂-NRR', wherein R and R' are each independently selected from the group consisting of hydrogen, alkyl, aryl, and carboxylic acid moieties. Suitable metal chelating agents include 1,3-dicarbonyl compounds of the general structure X-CHR-Y. In compounds of such formula, R is either a hydrogen atom or an aliphatic group, e.g., C₁-C₈ alkyl, aryl, alkenyl, etc. X and Y may be the same as or different from one another, and are functional groups containing multiply-bonded moieties with electron-withdrawing properties, as for example CONH₂, CONHR', CN, NO₂, SOR', or SO₂Z, in which R' represents a C₁-C₈ alkyl group and Z represents another atom or group, e.g., hydrogen, halo or C₁-C₈ alkyl.

Other chelating agent species useful in the compositions of the invention include amine trifluoroacetates of the general formula, R₁R₂R₃R₄N⁺ -O₂CCF₃ in which each of the R groups is independently selected from hydrogen and aliphatic groups, e.g., C₁-C₈ alkyl, aryl, alkenyl, etc.

The formulations of the invention optionally may also include such components as surfactants, stabilizers, corrosion inhibitors, buffering agents, and co-solvents, as useful or desired in a given end use application of formulations of the invention.

Formulations in accordance with the present invention are particularly useful on wafers that have been etched with chlorine- or fluorine-containing plasmas, followed by oxygen plasma ashing. The residues generated by this type of processing typically contain metal oxides. Such residues are often difficult to dissolve completely without causing corrosion of metal and titanium nitride features required for effective device performance. Also, metal oxide and silicon oxide slurry particles remaining after CMP will also be effectively removed by formulations in accordance with the present invention.

The features and advantages of the invention are more fully shown by the following non-limiting examples.

### EXAMPLE 1

Copper-specific corrosion inhibitors including either nitrogen-containing carboxylic acids or imines were tested in two different types of alkaline cleaning formulations, with the following components and characteristics.

**TABLE 1**

| | Components | Temp., °C | pH | Copper Etch Rate (Å/min) |
|---|---|---|---|---|
| Formulation 1 | dimethylacetoacetamide, amine, and water | 70 | 6.2 | 17.4 |
| Formulation 2 | ammonium fluoride, triethanolamine, pentamethdiethylenetriamine, and water | 40 | 8.6 | 7.5 |

The copper etch rate was determined by a standard four-point probe technique. Addition of corrosion inhibitors in accordance with the present invention significantly slowed down the copper etch rate, as shown by the following table, and effectively prevented undesirable corrosion during the cleaning process:

**TABLE 2**

| Corrosion Inhibitor | Temp. (°C) | Formulation Used | Concentration (%) | pH of solution | Copper Etch Rate (Å/min) | Reduction of Etch Rate (%) |
|---|---|---|---|---|---|---|
| Iminodiacetic Acid | 40 | 2 | 1.5 | 8.0 | 1-2 | -73.3-86.7 |
| Glycine | 40 | 2 | 1.5 | 9.2 | 3.6 | -52.0 |
| Nitrilotriacetic Acid | 40 | 2 | 1.5 | 8.2 | 3.6 | -52.0 |
| 1,1,3,3-tetramethylguanidine | 40 | 2 | 1.5 | 8.7 | 3.4 | -54.7 |
| CH₃C(=NCH₂CH₂OH)CH₂ C(O)N(CH₃)₂ | 70 | 1 | 24 | 10.9 | 6.2 | -64.4 |
| CH₃C(=NCH₂CH₂OCH₂CH₂OH) CH₂C(O)N(CH₃)₂ | 70 | 1 | 36 | 10.7 | 0.32 | -98.2 |
| CH₃C(=NH)CH₂C(O)CH₃ | 40 | 2 | 13.68 | 7.9 | 4.4 | -41.3 |

### EXAMPLE 2

A contamination test was carried out on Formulation 2 containing iminodiacetic acid inhibitor. The semiconductor wafer to be cleaned contained copper and silicon films. After the completion of the cleaning operation, the wafer was rinsed by deionized water at 25°C for about 15 minutes. The Secondary Ion Mass Spectrometry data (SIMS) obtained are as follows:

| | Cu (atoms/cm²) | F (atoms/cm²) | C (atoms/cm²) | CuₓO (Å) |
|---|---|---|---|---|
| Uncleaned Wafer | 1.6 x 10¹⁰ | 3.3 x 10¹³ | 7.5 x 10¹³ | 42 |
| Cleaned Wafer | 8.5 x 10⁹ | 5.1 x 10¹³ | 1.5 x 10¹³ | 15 |

The foregoing results show that the copper oxide GuₓO has been effectively removed by the cleaning process, while carbon contamination, which is mainly caused by the organic corrosion inhibitors in the cleaning formulation, has been greatly reduced.

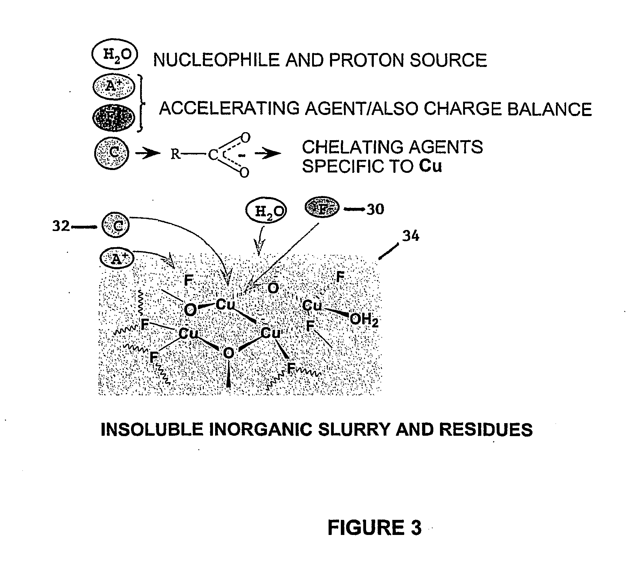

The present invention employs dilute alkaline fluoride in compositions for post CMP cleaning of silicon oxide or aluminum oxide particles from metallic surfaces such as copper or tungsten. FIGURE 3 depicts how the cleaning components of the present invention interact with the surface. Specially, FIGURE 3 depicts that Alkaline Fluoride 30 and chelating agents 32 dissolving inorganic oxide residues 34 after a CMP process.

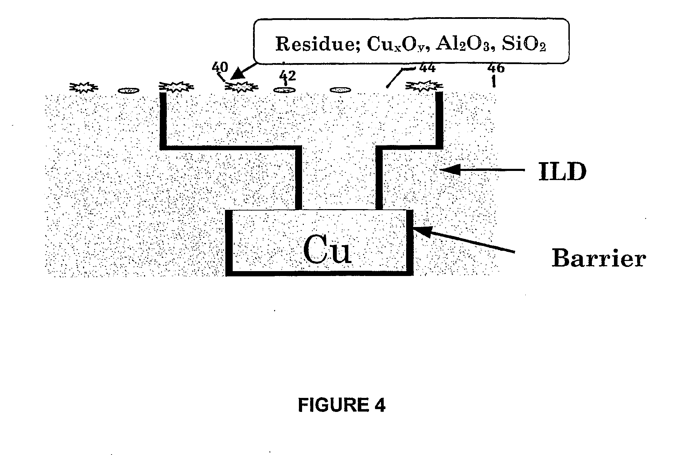

FIGURE 4 illustrates that the formulations taught by the present invention may be used to remove residues 40 and particles 42 for a copper surface 44. In FIGURE 4 particles 42 and residues 40 adhere to metal surface 44 as well as dielectric surface 46. Particles 42 and residues 40 may remain following a CMP process. The chemical solutions of the present invention degrade the attractive forces between the residue and the surface as well as dissolve copper and tungsten oxides and oxy-halides.

Formulations that have been found to be effective in cleaning residue and slurry particles from metal surfaces typically have pH values between about 7 and about 9. These formulations generally are aqueous solutions that comprise a fluoride source, an organic amine, and metal chelating agent. The individual constituents typically constitute a fluoride source and/or a derivative thereof as about 0.1 to about 4.2 % of the formulation. The fluoride source may include Ammonium Fluoride, Triethanolammonium Fluoride (TEAF), Diglycolammonium Fluoride (DGAF), Tetramethylammonium Fluoride (TMAF), Ammonium Bifluoride or other such fluoride sources as known to those skilled in the art. The organic Amine or mixture of two amines typically comprises between about 2% and about 11 % of the formulation of the present invention, wherein the organic amine can be one of many such organic amines known to those skilled in the art including Methydiethanolamine, Pentamethydiethylenediamine (PMDETA), Triethanolamine (TEA), Monoethanolamine, and Diglycolamine. The metal chelating agent or mixture of chelating agents typically comprises about 0 to about 4.2 % of the formulation. Typical metal chelating agent include: iminodiacetic acid, 2,4-pentanedione, methyldiethanolammonium trifluoroacetate, ammonium carbamate, ammonium pyrrolidinedithiocarbamate, ammonium lactate, malonic acid or other similar agents as known to those skilled in the art.

Several representative examples of formulations are:

| | | |
|---|---|---|
| a. | Triethanolamine | 4.5 % |
| | Ammonium Fluoride | 0.5 % |
| | Water | 95 % |
| | | |
| b. | PMDETA 3.8-4.5 % | |
| | Ammonium Fluoride | 0.5 % |
| | 2, 4-Pentanedione | 1 % |
| | Water | 94-94.7 % |
| | | |
| c. | TEA | 1.7 % |
| | PMDETA | 1.5 % |
| | TEAHF | 2% |
| | Iminodiacetic Acid | 0.4 % |
| | Ammonium Bifluoride | 0.5 % |
| | Water | 93.9 % |
| | | |
| | d. TEA | 3.5 % |
| | PMDETA | 1.5 % |
| | 2,4-Pentanedione | 1.35 % |
| | Ammonium Fluoride | 1.2 % |
| | Water | 92.45 % |
| | | |
| e. | TEA | 7 % |
| | PMDETA | 3 % |
| | 2, 4-Pentanedione | 2.7 % |
| | Ammonium Fluoride | 2.4 % |
| | Water | 84.9% |

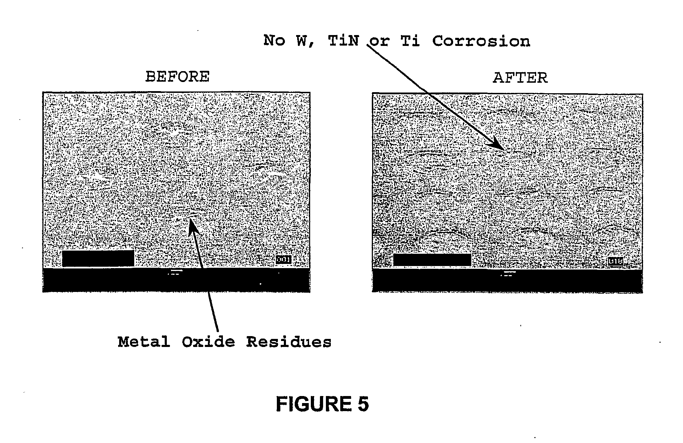

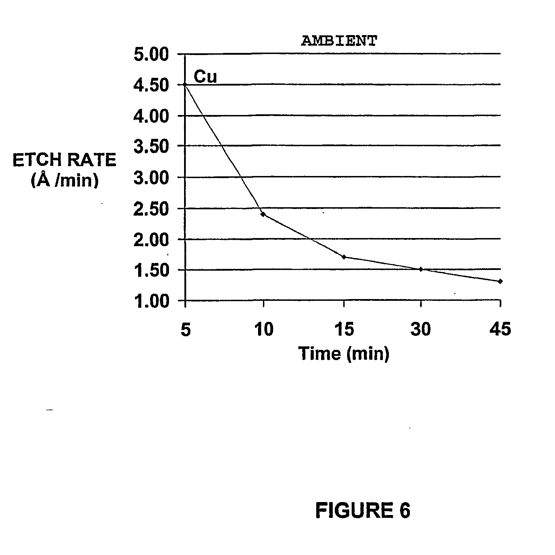

Wafers can be immersed in chemical solutions or chemicals can be applied to the wafer surface by spray or through a brush scrubbing system. FIGURE 5 depicts a SEM representing the results obtained with a standard immersion process. Specifically FIGURE 5 depicts Tungsten plugs after alumina slurry CMP and immersion in formula c for 10 min at 30 °C. Furthermore, selectivity to exposed materials may be illustrated by etch rate data. FIGURE 6 and table 3 illustrate the material etch rate on interconnect materials including an electroplated copper film.

**Table 3**

| **Material** | **Etch Rate, Å/min for 21° C @ 30 min** |
|---|---|
| **Copper** | **∼ 1** |
| **Tantalum Nitride** | **< 0.1** |
| **Titanium** | **< 0.1** |
| **Titanium Nitride** | **1.0** |
| **Tungsten** | **0.2** |
| **TEOS** | **1.5** |
| **BPSG** | **4.5** |

## Claims

1. A wafer cleaning formulation, including (i) a fluoride source, (ii) at least one organic amine, (iii) a nitrogen-containing carboxylic acid or an imine which provide functional groups that are specifically attracted to free copper atoms, (iv) water, and optionally at least one metal chelating agent.

2. The cleaning formulation of claim 1, comprising the following components in the percentage by weight ranges shown, based on the total weight of such components:
| | |
|---|---|
| fluoride source | 1-21% |
| organic amine(s) | 20-55% |
| a nitrogenous component, selected from nitrogen-containing | |
| carboxylic acids and imines which provide functional groups that | |
| are specifically attracted to free copper atoms | 0.5-40% |
| water | 23-50% |
| metal chelating agent(s) | 0-21% |
| TOTAL | 100% |

3. The cleaning formulation of claim 1 or 2, including at least one metal chelating agent selected from the group consisting of:
acetoacetamide,
ammonium carbamate,
ammonium pyrrolidinedithiocarbamate (APDC),
dimethyl malonate,
methyl acetoacetate,
N-methyl acetoacetamide,
2,4-pentanedione,
tetramethylammonium thiobenzoate,
tetramethylammonium trifluoroacetate, and
tetramethylthiuram disulfide (TMTDS)
ammonium lactate,
malonic acid,
methyldiethanolammonium trifluoroacetate.

4. The cleaning formulation of claim 1 or 2, wherein said fluoride source comprises a species selected from the group consisting of
ammonium fluoride,
triethanolammonium fluoride (TEAF),
diglycolammonium fluoride (DGAF),
tetramethylammonium fluoride (TMAF), and
triethylamine tris (hydrogen fluoride) (TREAT-HF).

5. The cleaning formulation of claim 4, wherein said fluoride source comprises a fluoride species selected from the group consisting of:
ammonium fluoride; and
triethanolammonium fluoride (TEAF).

6. The cleaning formulation of claim 4 or 5, wherein said fluoride source comprises triethanolammonium fluoride (TEAF).

7. The cleaning formulation of claim 1 or 2, wherein said organic amine(s) comprises an amine selected from the group consisting of:
diglycolamine (DGA),
methyldiethanolamine (MDEA),
pentamethyldiethylenetriamine (PMDETA),
triethanolamine (TEA),
triethylenediamine (TEDA),
hexamethylenetetramine,
3, 3-iminobis (N,N-dimethylpropylamine), and
monoethanolamine.

8. The cleaning formulation of claim 7, wherein said organic amine(s) comprise an amine selected from the group consisting of:
diglycolamine (DGA),
methyldiethanolamine (MDEA),
pentamethyldiethylenetriamine (PMDETA),
triethanolamine (TEA), and
triethylenediamine (TEDA).

9. The cleaning formulation of claim 7 or 8, wherein said organic amine(s) comprises methyldiethanolamine (MDEA) or pentamethyldiethylenetriamine (PMDETA).

10. The cleaning formulation of claim 1 or 2, wherein said nitrogenous component comprises a species from the group consisting of:
iminodiacetic acid (IDA)
glycine
nitrilotriacetic acid (NTA)
1,1,3,-tetramethylgvanidine (TMG)
CH₃C(=NCH₂CH₂OH)CH₂C(O)N(CH₃)₂
CH₃C(=NCH₂CH₂OCH₂CH₂OH)CH₂C(O)N(CH₃)₂
CH₃C(=NH)CH₂C(O)CH₃
(CH₃CH₂)₂NC(=NH)N(CH₃CH₂)₂
HOOCCH₂N(CH₃)₂
HOOCCH₂N(CH₃)CH₂COOH

11. The cleaning formulation of claim 10, wherein said nitrogenous component comprises a species selected from the group consisting of:
iminodiacetic acid (IDA);
glycine;
nitrilotriacetic acid (NTA); and
1,1,3,3-tetramethylguanidine (TMG).

12. The cleaning formulation of claim 10 or 11, wherein said nitrogenous component comprises iminodiacetic acid (IDA).

13. The cleaning formulation of claim 1 or 2, wherein said fluoride source comprises a species selected from the group consisting of:
ammonium fluoride,
triethanolammonium fluoride (TEAF),
diglycolammonium fluoride (DGAF),
tetramethylammonium fluoride (TMAF), and
triethylamine tris (hydrogen fluoride) (TREAT-HF);
said organic amine(s) comprise a species selected from the group consisting of:
diglycolamine (DGA),
methyldiethanolamine (MDEA),
pentamethyldiethylenetriamine (PMDETA),
triethanolamine (TEA),
triethylenediamine (TEDA),
hexamethylenetetramine,
3, 3-iminobis (N,N-dimethylpropylamine), and
monoethanolamine;
said nitrogenous component comprises a species selected from the group consisting of:
iminodiacetic acid (IDA)
glycine
nitrilotriacetic acid (NTA)
1,1,3,3-tetramethylguanidine (TMG)
and said formulation includes a metal chelating agent comprising a species selected from the group consisting of:
acetoacetamide,
ammonium carbamate,
ammonium pyrrolidinedithiocarbamate (APDC),
dimethyl malonate,
methyl acetoacetate,
N-methyl acetoacetamide,
2,4-pentanedione,
tetramethylammonium thiobenzoate,
tetramethylammonium trifluoroacetate, and
tetramethylthiuram disulfide (TMTDS),
ammonium lactate,
malonic acid,
methyldiethanolanimonium trifluoroacetate.

14. The cleaning formulation of claim 1 or 2, wherein said fluoride source comprises a compound having the general formula R₁R₂R₃R₄NF in which each of the R groups is independently selected from hydrogen atoms and aliphatic groups, and wherein said formulation includes a metal chelating agent of the formula:
X-CHR-Y, in which
R is either hydrogen or a C₁-C₈ alkyl group and
X and Y are functional groups containing multiply bonded moieties having electron-withdrawing properties.

15. The cleaning formulation of claim 14, wherein each of X and Y is independently selected from CONH₂, CONHR', CN, NO₂, SOR', and SO₂Z in which R' is a C₁-C₈ alkyl and Z is hydrogen, halo, or a C₁-C₈ alkyl.

16. The cleaning formulation of claim 1 or 2, wherein said fluoride source comprises a compound having the formula R₁R₂R₃R₄NF in which each of the R groups is hydrogen or a C₁-C₈ alkyl, and wherein said formulation includes a metal chelating agent of the formula, R₁R₂R₃R₄N^{+ -}O₂CCF₃ in which each of the R groups is independently hydrogen or a C₁-C₈ alkyl group.

17. The cleaning formulation of claim 1 or 2, wherein said nitrogenous component includes a compound having the formula:
COOH-CH₂-NRR'
wherein each of R and R' is independently selected from the group consisting of hydrogen, alkyl, aryl, and carboxylic acids.

18. A method of removing residue from a semiconductor wafer, comprising contacting the wafer with a cleaning formulation as defined in any of claims 1-17.

19. A method for fabricating a semiconductor wafer including the steps comprising:
plasma etching a metalized layer from a surface of the wafer;
plasma ashing a resists from the surface of the wafer, and
contacting the wafer with the cleaning formulation of any of claims 1-17.

## Patentansprüche

1. Wafer-Reinigungsformulierung, enthaltend (i) eine Fluoridquelle, (ii) mindestens ein organisches Amin, (iii) eine Stickstoff enthaltende Carbonsäure oder ein Imin, die funktionelle Gruppen liefern, welche spezifisch von freien Kupferatomen angezogen werden, (iv) Wasser und wahlweise mindestens einen Metallchelatbildner.

2. Reinigungsformulierung nach Anspruch 1, umfassend die folgenden Bestandteile in den gezeigten Gewichtsprozentbereichen, bezogen auf das Gesamtgewicht dieser Bestandteile:
| | |
|---|---|
| Fluoridquelle | 1-21 % |
| organische(s) Amin(e) | 20-55 % |
| einen stickstoffhaltigen Bestandteil, ausgewählt aus Stickstoff | |
| enthaltenden Carbonsäuren und Iminen, die funktionelle | |
| Gruppen liefern, welche spezifisch von freien Kupferatomen | |
| angezogen werden | 0,5-40 % |
| Wasser | 23-50 % |
| Metallchelatbildner | 0-21 % |
| GESAMT | 100 % |

3. Reinigungsformulierung nach Anspruch 1 oder 2, enthaltend mindestens einen Metallchelatbildner, ausgewählt aus der Gruppe bestehend aus:
Acetoacetamid,
Ammoniumcarbamat,
Ammoniumpyrrolidindithiocarbamat (APDC),
Dimethylmalonat,
Methylacetoacetat,
N-Methylacetoacetamid,
2,4-Pentandion,
Tetramethylammoniumthiobenzoat,
Tetramethylammoniumtrifluoracetat, und
Tetramethylthiuramdisulfid (TMTDS)
Ammoniumlactat,
Malonsäure,
Methyldiethanolammoniumtrifluoracetat.

4. Reinigungsformulierung nach Anspruch 1 oder 2, wobei die Fluoridquelle eine Art umfasst, die aus der Gruppe bestehend aus:
Ammoniumfluorid,
Triethanolammoniumfluorid (TEAF),
Diglycolammoniumfluorid (DGAF),
Tetramethylammoniumfluorid (TMAF) und
Triethylamin-tris(wasserstofffluorid) (TREAT-HF)
ausgewählt ist.

5. Reinigungsformulierung nach Anspruch 4, wobei die Fluoridquelle eine Fluorid-Spezies umfasst, die aus der Gruppe bestehend aus:
Ammoniumfluorid; und
Triethanolammoniumfluorid (TEAF)
ausgewählt ist.

6. Reinigungsformulierung nach Anspruch 4 oder 5, wobei die Fluoridquelle Triethanolammoniumfluorid (TEAF) umfasst.

7. Reinigungsformulierung nach Anspruch 1 oder 2, wobei das organische Amin bzw. die organischen Amine ein Amin umfassen, das aus der Gruppe bestehend aus:
Diglycolamin (DGA),
Methyldiethanolamin (MDEA),
Pentamethyldiethylentriamin (PMDETA),
Triethanolamin (TEA),
Triethylendiamin (TEDA),
Hexamethylentetramin,
3,3-lminobis(N,N-dimethylpropylamin) und
Monoethanolamin
ausgewählt ist.

8. Reinigungsformulierung nach Anspruch 7, wobei das organische Amin bzw. die organischen Amine ein Amin umfassen, das aus der Gruppe bestehend aus:
Diglycolamin (DGA),
Methyldiethanolamin (MDEA),
Pentamethyldiethylentriamin (PMDETA),
Triethanolamin (TEA) und
Triethylendiamin (TEDA)
ausgewählt ist.

9. Reinigungsformulierung nach Anspruch 7 oder 8, wobei das organische Amin bzw. die organischen Amine Methyldiethanolamin (MDEA) oder Pentamethyldiethylentriamin (PMDETA) umfassen.

10. Reinigungsformulierung nach Anspruch 1 oder 2, wobei der stickstoffhaltige Bestandteil eine Spezies aus der Gruppe bestehend aus Iminodiessigsäure (IDA),
Glycin,
Nitrilotriessigsäure (NTA),
1,1,3-Tetramethylguanidin (TMG),
CH₃C(=NCH₂CH₂OH)CH₂C(O)N(CH₃)2
CH₃C(=NCH₂CH₂OCH₂CH₂OH)CH₂C(O)N(CH₃)₂
CH₃C(=NH)CH₂C(O)CH₃
(CH₃CH₂)₂NC(=NH)N(CH₃CH₂)₂
HOOCCH₂N(CH₃)₂
HOOCCH₂N(CH₃)CH₂COOH
umfasst.

11. Reinigungsformulierung nach Anspruch 10, wobei der stickstoffhaltige Bestandteil eine Spezies umfasst, die aus der Gruppe bestehend aus:
Iminodiessigsäure (IDA);
Glycin;
Nitrilotriessigsäure (NTA); und
1,1,3,3-Tetramethylguanidin (TMG)
ausgewählt ist.

12. Reinigungsformulierung nach Anspruch 10 oder 11, wobei der stickstoffhaltige Bestandteil Iminodiessigsäure (IDA) umfasst.

13. Reinigungsformulierung nach Anspruch 1 oder 2, wobei die Fluoridquelle eine Spezies umfasst, die aus der Gruppe bestehend aus:
Ammoniumfluorid,
Triethanolammoniumfluorid (TEAF),
Diglycolammoniumfluorid (DGAF),
Tetramethylammoniumfluorid (TMAF) und
Triethylamin-tris(wasserstofffluorid) (TREAT-HF)
ausgewählt ist;
das organische Amin bzw. die organischen Amine eine Spezies umfassen, die aus der Gruppe bestehend aus:
Diglycolamin (DGA),
Methyldiethanolamin (MDEA),
Pentamethyldiethylentriamin (PMDETA),
Triethanolamin (TEA),
Triethylendiamin (TEDA),
Hexamethylentetramin,
3,3-lminobis(N,N-dimethylpropylamin) und
Monoethanolamin
ausgewählt ist;
der stickstoffhaltige Bestandteil eine Spezies umfasst, die aus der Gruppe bestehend aus:
Iminodiessigsäure (IDA)
Glycin
Nitrilotriessigsäure (NTA)
1,1,3,3-Tetramethylguanidin (TMG)
ausgewählt ist;
und die Formulierung einen Metallchelatbildner aufweist, der eine Spezies umfasst, die aus der Gruppe bestehend aus:
Acetoacetamid,
Ammoniumcarbamat,
Ammoniumpyrrolidindithiocarbamat (APDC),
Dimethylmalonat,
Methylacetoacetat,
N-Methylacetoacetamid,
2,4-Pentandion,
Tetramethylammoniumthiobenzoat,
Tetramethylammoniumtrifluoracetat und
Tetramethylthiuramdisulfid (TMTDS),
Ammoniumlactat,
Malonsäure,
Methyldiethanolammoniumtrifluoracetat
ausgewählt ist.

14. Reinigungsformulierung nach Anspruch 1 oder 2, wobei die Fluoridquelle eine Verbindung umfasst, die die allgemeine Formel R₁R₂R₃R₄N_{F} aufweist, worin die R-Gruppen jeweils unabhängig voneinander aus Wasserstoffatomen und aliphatischen Gruppen ausgewählt sind, und wobei die Formulierung einen Metallchelatbildner der Formel:
X-CHR-Y umfasst, worin
R entweder Wasserstoff oder eine C₁-C₈-Alkylgruppe ist und
X und Y funktionelle Gruppen sind, die mehrfach gebundene Reste mit elektronenfangenden Eigenschaften enthalten.

15. Reinigungsformulierung nach Anspruch 14, wobei X und Y jeweils unabhängig voneinander aus CONH₂, CONHR', CN, NO₂, SOR' und SO₂Z ausgewählt sind, worin R' ein C₁-C₈-Alkyl ist und Z ein Wasserstoff, Halo oder ein C₁-C₈-Alkyl ist.

16. Reinigungsformulierung nach Anspruch 1 oder 2, wobei die Fluoridquelle eine Verbindung umfasst, die die Formel R₁R₂R₃R₄NF aufweist, worin die R-Gruppen jeweils Wasserstoff oder ein C₁-C₈-Alkyl sind, und wobei die Formulierung einen Metallchelatbildner der Formel R₁R₂R₃R₄N⁺-O₂CCF₃ aufweist, worin die R-Gruppen jeweils unabhängig voneinander Wasserstoff oder eine C₁-C₈-Alkylgruppe sind.

17. Reinigungsformulierung nach Anspruch 1 oder 2, wobei der stickstoffhaltige Bestandteil eine Verbindung mit der Formel:
COOH-CH₂-CRR
umfasst,
wobei R und R' jeweils unabhängig voneinander aus der Gruppe bestehend aus Wasserstoff, Alkyl, Aryl und Carbonsäuren ausgewählt sind.

18. Verfahren zum Entfernen eines Rückstands aus einem Halbleiterwafer, umfassend das Kontaktieren des Wafers mit einer Reinigungsformulierung nach einem der Ansprüche 1 bis 17.

19. Verfahren zur Herstellung eines Halbleiterwafers, enthaltend die Schritte, umfassend:
Plasmaätzen einer metallisierten Schicht von einer Oberfläche des Wafers;
Plasmaveraschung eines Resists von der Oberfläche des Wafers und
Kontaktieren des Wafers mit der Reinigungsformulierung nach einem der Ansprüche 1 bis 17.

## Revendications

1. Formulation de nettoyage de plaquette, comprenant : (i) une source de fluorure, (ii) au moins une amine organique, (iii) un acide carboxylique contenant de l'azote ou une imine procurant des groupes fonctionnels spécifiquement attirés par des atomes libres de cuivre, (iv) de l'eau et, de façon optionnelle, au moins un agent chélateur de métal.

2. Formulation de nettoyage selon la revendication 1, comprenant les composants suivants, dont les proportions en masse sont indiquées, en se fondant sur la masse totale de ces composants :
| | |
|---|---|
| - source de fluorure | 1 à 21 % |
| - amine(s) organique(s) | 20 à 55% |
| - composant azoté, sélectionné parmi des acides carboxyliques contenant de l'azote et des imines procurant des groupes fonctionnels spécifiquement attirés par des atomes libres de cuivre | 0,5 à 40 % |
| - eau | 23 à 50 % |
| - agent(s) chélateur(s) de métal | 0 à 21 % |
| Total | 100 % |

3. Formulation de nettoyage selon la revendication 1 ou 2, incluant au moins un agent chélateur de métal, sélectionné parmi le groupe constitué par :
- un acétoacétamide,
- un carbamate d' ammonium,
- un pyrrolidinedithiocarbamate d'ammonium (APDC),
- un malonate de diméthyle,
- un acétoacétate de méthyle,
- un acétoacétamide de N-méthyle,
- un 2, 4-pentanedione,
- un thiobenzoate de tétraméthylammonium,
- un trifluoroacétate de tétraméthylammonium et
- un disulfure de tétraméthylthiurame (TMTDS),
- un lactate d'ammonium,
- un acide malonique,
- un trifluoroacétate de méthyldiéthanolammonium.

4. Formulation de nettoyage selon la revendication 1 ou 2, dans laquelle ladite source de fluorure comprend un type sélectionné parmi le groupe constitué par :
- un fluorure d'ammonium,
- un fluorure de triéthanolammonium (TEAF),
- un fluorure de diglycolammonium (DGAF),
- un fluorure de tétraméthylammonium (TMAF) et
- un trihydrofluorure de triéthylamine (TREAT-HF).

5. Formulation de nettoyage selon la revendication 4, dans laquelle ladite source de fluorure comprend un type de fluorure sélectionné parmi le groupe constitué par :
- un fluorure d'ammonium ; et
- un fluorure de triéthanolammonium (TEAF).

6. Formulation de nettoyage selon la revendication 4 ou 5, dans laquelle ladite source de fluorure comprend un fluorure de triéthanolammonium (TEAF).

7. Formulation de nettoyage selon la revendication 1 ou 2, dans laquelle le(s)dit(s) amine(s) organique(s) comprend une amine sélectionnée parmi le groupe constitué par :
- une diglycolamine (DGA),
- une méthyldiéthanolamine (MDEA),
- une pentaméthyldiéthylènetriamine (PMDETA),
- une triéthanolamine (TEA),
- une triéthylènediamine (TEDA),
- une hexaméthylènetétramine,
- une 3, 3-iminobis (N, N-diméthylpropylamine) et
- une monoéthanolamine.

8. Formulation de nettoyage selon la revendication 7, dans laquelle ladite(s) amine(s) organique(s) comprend une amine sélectionnée parmi le groupe constitué par :
- une diglycolamine (DGA),
- une méthyldiéthanolamine (MDEA),
- une pentaméthyldiéthylènetriamine (PMDETA),
- une triéthanolamine (TEA) et
- ne triéthylènediamine (TEDA).

9. Formulation de nettoyage selon la revendication 7 ou 8, dans laquelle ladite(s) amine(s) organique(s) comprend une méthyldiéthanolamine (MDEA) ou une pentaméthyldiéthylènetriamine (PMDETA).

10. Formulation de nettoyage selon la revendication 1 ou 2, dans laquelle ledit composant azoté comprend un type parmi le groupe constitué par :
- un acide iminodiacétique (IDA),
- une glycine,
- un acide nitrilotriacétique (NTA),
- un 1, 1, 3, 3-tétraméthylguanidine (TMG),
- un CH₃C(=NCH₂CH₂OH)CH₂C(O)N(CH₃)₂,
- un CH₃C(=NCH₂CH₂OCH₂CH₂OH)CH₂C(O)N(CH₃)₂,
- un CH₃C(=NH)CH₂C(O)CH₃,
- un (CH₃CH₂)₂NC(=NH)N(CH₃CH₂)₂,
- un HOOCCH₂N(CH₃)₂,
- un HOOCCH₂N(CH₃)CH₂COOH.

11. Formulation de nettoyage selon la revendication 10, dans laquelle ledit composant azoté comprend un type sélectionné parmi le groupe constitué par :
- un acide iminodiacétique (IDA) ;
- une glycine ;
- un acide nitrilotriacétique (NTA) ; et
- un 1, 1, 3, 3-tétraméthylguanidine (TMG).

12. Formulation de nettoyage selon la revendication 10 ou 11, dans laquelle ledit composant azoté comprend un acide iminodiacétique (IDA).

13. Formulation de nettoyage selon la revendication 1 ou 2, dans laquelle ladite source de fluorure comprend un type sélectionné parmi le groupe constitué par :
- un fluorure d'ammonium,
- un fluorure de triéthanolammonium (TEAF),
- un fluorure de diglycolammonium (DGAF),
- un fluorure de tétraméthylammonium (TMAF) et
- un trihydrofluorure de triéthylamine (TREAT-HF) ;
ladite(s) amine(s) organique(s) comprend une amine sélectionnée parmi le groupe constitué par :
- une diglycolamine (DGA),
- une méthyldiéthanolamine (MDEA),
- une pentaméthyldiéthylènetriamine (PMDETA),
- une triéthanolamine (TEA),
- une triéthylènediamine (TEDA),
- une hexaméthylènetétramine,
- une 3, 3-iminobis (N, N-diméthylpropylamine) et
- une monoéthanolamine ;
ledit composant azoté comprend un type sélectionné parmi le groupe constitué par :
- un acide iminodiacétique (IDA),
- une glycine,
- un acide nitrilotriacétique (NTA) et
- un 1, 1, 3, 3-tétraméthylguanidine (TMG) ;
et ladite formulation inclut un agent chélateur de métal comprenant un type sélectionné parmi le groupe constitué par :
- un acétoacétamide,
- un carbamate d'ammonium,
- un pyrrolidinedithiocarbamate d'ammonium (APDC),
- un malonate de diméthyle,
- un acétoacétate de méthyle,
- un acétoacétamide de N-méthyle,
- un 2, 4-pentanedione,
- un thiobenzoate de tétraméthylammonium,
- un trifluoroacétate de tétraméthylammonium et
- un disulfure de tétraméthylthiurame (TMTDS),
- un lactate d'ammonium,
- un acide malonique,
- un trifluoroacétate de méthyldiéthanolammonium.

14. Formulation de nettoyage selon la revendication 1 ou 2, dans laquelle ladite source de fluorure comprend un composé ayant la formule générale R₁R₂R₃RaNF, dans laquelle chacun des groupes R est sélectionné indépendamment parmi des atomes d'hydrogène et des groupes aliphatiques, et dans laquelle ladite formulation inclut un agent chélateur de métal de formule :
- X-CHR-Y, dans laquelle
- R est soit un hydrogène, soit un groupe alkyl C₁-C₈, et
- X et Y sont des groupes fonctionnels contenant de multiples fractions liées ayant des propriétés de retrait d'électrons.

15. Formulation de nettoyage selon la revendication 14, dans laquelle chacun des groupes X et Y est sélectionné indépendamment parmi les groupes CONH₂, CONHR', CN, NO₂, SOR' et SO₂Z, dans lesquels R' est un alkyl C₁-C₈ et Z est un hydrogène, un halogène ou un alkyl C₁-C₈.

16. Formulation de nettoyage selon la revendication 1 ou 2, dans laquelle ladite source de fluorure comprend un composé ayant la formule R₁R₂R₃R₄NF, dans laquelle chacun des groupes R est un hydrogène ou un alkyl C₁-C₈, et dans laquelle ladite formulation inclut un agent chélateur de métal de formule :
- R₁R₂R₃R₄N^{+ -}O₂CCF₃, dans laquelle chacun des groupes R est indépendamment un hydrogène ou un groupe alkyl C₁-C₈.

17. Formulation de nettoyage selon la revendication 1 ou 2, dans laquelle ledit composant azoté inclut un composé ayant la formule :
- COOH-CH₂-NRR',
- dans laquelle chacun des groupes R et R' est sélectionné indépendamment parmi le groupe constitué par un hydrogène, un alkyle, un aryle et des acides carboxyliques.

18. Procédé pour enlever des résidus d'une plaquette de semi-conducteur, comprenant l'étape consistant à amener au contact de la plaquette une formulation de nettoyage telle que définie dans l'une quelconque des revendications 1 à 17.

19. Procédé de fabrication d'une plaquette de semi-conducteur, comprenant les étapes consistant à :
- graver au plasma une couche métallisée sur une surface de la plaquette ;
- réduire en cendres par plasma un résist à la surface de la plaquette ; et
- amener au contact de la plaquette la formulation de nettoyage selon l'une quelconque des revendications 1 à 17.
